# EUROPÄISCHE PATENTSCHRIFT

(11) **EP 1 004 126 B1**
(45) Veröffentlichungstag und Bekanntmachung des Hinweises auf die Patenterteilung: **15.08.2007**
(21) Anmeldenummer: 98922590.9
(22) Anmeldetag: 11.03.1998
(51) Int. Cl.: H01F 27/29

(54) **ELEKTRISCHES BAUELEMENT, INSBESONDERE CHIP-INDUKTIVITÄT**
ELECTRICAL COMPONENT, SPECIALLY A CHIP INDUCTIVE RESISTOR
COMPOSANT ELECTRIQUE, EN PARTICULIER UNE INDUCTANCE PASTILLE

(30) Priorität: 13.03.1997 DE 19710462
(43) Veröffentlichungstag der Anmeldung: 31.05.2000
(73) Patentinhaber: EPCOS AG, 81669 München (DE)
(72) Erfinder: ECKARDT, Hans-Dieter, D-89542 Herbrechtingen (DE); ESPENHAIN, Manfred, D-89522 Heidenheim (DE); SCHERER, Wilfried, D-89518 Heidenheim (DE); SCHILLING, Bruno, D-89429 Bachhagel (DE)
(74) Vertreter: Epping - Hermann - Fischer
(86) Internationale Anmeldenummer: PCT/DE1998/000733
(87) Internationale Veröffentlichungsnummer: WO 1998/040897

(56) Entgegenhaltungen:
- EP-A- 0 702 378
- US-A- 4 725 806
- US-A- 4 797 648
- US-A- 5 003 279

## Beschreibung

Die Erfindung betrifft ein elektrisches Bauelement, insbesondere Chip-Induktivität zur Oberflächenmontage, mit auf den Bauelementekörper abgebogenen Kontaktelementen aus Metallblech, die zumindest in einem lötbaren Bereich einen Überzug aus lötbaren Werkstoffen besitzen.

Derartige Bauelemente sind beispielsweise aus dem Siemens Matsushita Components Datenbuch 1992/93 "EMV Bauelemente", Seiten 110 - 118, bekannt.

Zum Einsatz, beispielsweise in HF-Schaltungen, werden diese Bauelemente auf den Platinen verlötet. Die Verlötung geschieht mittels einer Reflow- bzw. Wellenlötung gemäß CECC 00802, Ausgabe 2, 1994. Demnach müssen > 95 % der Bauelementeanschlußfläche nach beschleunigter Alterung benetzbar sein.

Die obengenannten bekannten Chip-Induktivitäten aus dem Siemens Matsushita Components Datenbuch genügen dieser Forderung. Sie besitzen Kontaktelemente aus Bronzeblech (CuSn6) und weisen im lötbaren Bereich eine Versilberung auf, die beispielsweise galvanisch aufgebracht ist. Bei diesen vor dem Biegen aufgebrachten Silberendoberflächen treten nur sehr wenig Biegerisse auf, die beim Umbiegen der Kontaktelemente auf den Bauelementekörper auftreten können. Dies wird vor allem auf die hohe Bruchfestigkeit des Silbers von ca. 40 % zurückgeführt. Allerdings können bei Silberendoberflächen Schwierigkeiten auftreten, wie zum Beispiel eine Abnahme der Lötbarkeit durch Sulfidbildung bei Lagerung in Industrieatmosphäre, sowie eine mögliche Silberwanderung (Migration) und Whiskerbildung. Beim Wellenlöten wird die Silberoberfläche der Anschlußelemente vollständig mit Lot bedeckt, wogegen beim Reflowlöten nur eine partielle Bedeckung vorliegt. Silberwanderung und Whiskerbildung können nur an nicht verzinnter Silberoberfläche auftreten, so daß beim Reflowlöten ein Restrisiko hinsichtlich Silberwanderung und Whiskerbildung besteht.

Weiterhin sind Endoberflächen bekannt, die erst nach dem Biegen der Kontaktelemente durch eine Nachverzinnung aufgebracht werden. Dabei werden Flußmittel verwendet, die entweder nicht beziehungsweise schwach aktiviert sind (wie beim Auflöten der Bauelemente auf die Platinen), oder es werden stärker aktivierte Flußmittel als beim Auflöten auf die Platinen verwendet. Eine reproduzierbare Verbesserung der Lötbarkeit durch Nachverzinnen wird dabei nur mit stark aktivierten Flußmitteln erreicht. Hierbei ist allerdings ein Waschen als zusätzlicher Arbeitsgang erforderlich, um die Korrosionsgefahr zu verringern.

Weiterhin sind Endoberflächen bekannt, die vor dem Biegen der Kontaktelemente durch galvanische Beschichtung oder zum Beispiel durch Heißverzinnen aufgebracht werden, die keine Silberendoberfläche besitzen, und die nach dem Biegen nicht mehr durch Nachverzinnen, mechanische Bearbeitung usw. verändert werden, zum Beispiel Zinn- und Zinn-Blei-Endoberflächen mit Unternickelung auf Kupferschichten. Bei diesen Endoberflächen führt die Biegebeanspruchung allerdings in der Regel zu derartigen Biegerissen, daß die Kontaktelemente im Biegebereich nur noch schlecht oder nicht mehr lötbar sind, so daß insbesondere bei miniaturisierten Bauelementen eine Lötbarkeit mit > 95 % Benetzung nicht mehr erreicht wird. Ursache der Biegerisse sind dabei zu geringe Bruchfestigkeit des Beschichtungsmaterials und eine zu geringe Haftung der Beschichtung auf den Kontaktelementen.

Aufgabe der vorliegenden Erfindung ist es, ein elektrisches Bauelement der eingangs angegebenen Art zu schaffen, das lötbar ist gemäß CECC 00802, nach dem Biegen keine Nachbehandlung der Anschlußoberfläche erforderlich macht und nicht die mit einer Silberendoberfläche verbundenen Schwierigkeiten aufweist.

Diese Aufgabe wird erfindungsgemäß dadurch gelöst, daß auf den Kontaktelementen eine Haftschicht, auf der Haftschicht eine lötbare Zwischenschicht mit hoher Bruchfestigkeit und auf der Zwischenschicht eine äußere lötbare Endbeschichtung angeordnet sind.

Bei Kontaktelementen aus Bronze (CuSn6) besteht die Haftschicht vorteilhafterweise aus Kupfer, die bruchfeste lötbare Zwischenschicht aus Silber und die Endbeschichtung aus Zinn oder einer Zinn-Blei-Legierung.

In vorteilhafter Weise betragen die Schichtdicken der Kupfer-Haftschicht ca. 0,4 µm, der Silber-Zwischenschicht 1 - 2 µm und der Zinn- bzw. Zinn-Blei-Endschicht 5 - 7 µm.

Der Vorteil der bruchfesten, lötbaren Zwischenschicht, insbesondere aus Silber, besteht darin, daß zwar die Endschicht aus Zinn bzw. Zinn-Blei reißt, daß Risse in der Silberschicht selbst aber nur in so geringem Maße auftreten, daß in den Biegerissen auf dem Silber mit einer Benetzung > 95 % gelötet wird.

Ohne Silber-Zwischenschicht würde dagegen, zum Beispiel bei Zinnoberflächen mit Unternickelung und Kupfer-Haftschichten in den Biegerissen auf dem Basismaterial, auf dem Kupfer der Haftschicht bzw. auf dem Nickel der Sperrschicht, gelötet werden, die insbesondere nach der beschleunigten Alterung mit 155 °C oder Wasserdampf nicht mehr benetzt werden.

Die auf den Kontaktelementen nach der Erfindung angeordnete Kupferschicht hat nicht nur die Funktion einer Haftschicht, sondern dient gleichzeitig als Lötpartner, wenn bei zu starker Lötbeanspruchung die Silber-Zwischenschicht ablegiert wird.

Insgesamt ergeben sich bei einer Anschlußbeschichtung gemäß der Erfindung die Vorteile, daß im Gegensatz zu einer Zinn- bzw. Zinn-Blei-Endoberfläche ohne Silber-Zwischenschicht auch mit Voralterung eine Benetzbarkeit > 95 % reproduzierbar erreicht wird. Weiterhin besteht der Vorteil, daß beim Auftreten von Biegerissen zwar Sulfidschichten auf dem Silber gebildet werden können, daß damit aber die Beschichtung nur in den Biegerissen selbst unlötbar wird, wogegen im wesentlich größeren verzinnten Teil der Anschlußoberfläche außerhalb des Biegebereichs die Lötbarkeit weiterhin garantiert ist. Schließlich wird beim Reflowlöten im Bereich der Zinn- bzw. Zinn-Blei-Endoberfläche in den nicht vom Lot kontaktierten Bereichen der Anschlüsse Silberwanderung und Whiskerbildung verhindert, deren Auftreten an nicht verzinnter Silberendoberfläche nicht auszuschließen ist.

## Patentansprüche

1. Elektrisches Bauelement, insbesondere Chip-Induktivität zur Oberflächenmontage, mit auf den Bauelementekörper abgebogenen Kontaktelementen aus Metallblech, die zumindest in einem lötbaren Bereich einen Überzug aus einem lötbaren Werkstoff besitzen,
**dadurch gekennzeichnet,**
**daß** auf den Kontaktelementen eine Haftschicht, auf der Haftschicht eine Zwischenschicht und auf der Zwischenschicht eine äußere Endbeschichtung angeordnet sind.

2. Elektrisches Bauelement nach Anspruch 1,
**dadurch gekennzeichnet,**
**daß** die Kontaktelemente aus Bronze bestehen.

3. Elektrisches.Bauelement nach Anspruch 2,
**dadurch gekennzeichnet,**
**daß** die Kontaktelemente aus CuSn6 bestehen.

4. Elektrisches Bauelement nach einem der Ansprüche 1 - 3,
**dadurch gekennzeichnet,**
**daß** die Haftschicht aus Kupfer besteht.

5. Elektrisches Bauelement nach einem der Ansprüche 1 - 4,
**dadurch gekennzeichnet,**
**daß** die Zwischenschicht aus Silber besteht.

6. Elektrisches Bauelement nach einem der Ansprüche 1 - 5,
**dadurch gekennzeichnet,**
**daß** die Endbeschichtung aus Zinn oder einer Zinn/Blei-Legierung besteht.

7. Elektrisches Bauelement nach einem der Ansprüche 4 - 6,
**dadurch gekennzeichnet,**
**daß** die Schichtdicken der Kupfer-Haftschicht ca. 0,4µm, der Silber-Zwischenschicht 1 - 2 µm und der Zinn- bzw. Zinn/Blei-Endschicht 5 - 7 µm betragen.

## Claims

1. Electrical component, in particular chip inductor for surface mounting, having sheet-metal contact elements bent over onto the component body, which have a coating made of a solderable material at least in a solderable area,
**characterized in that**
a bonding layer is arranged on the contact elements, an intermediate layer is arranged on the bonding layer, and an outer top coating is arranged on the intermediate layer.

2. Electrical component according to Claim 1,
**characterized in that**
the contact elements are made of bronze.

3. Electrical component according to Claim 2,
**characterized in that**
the contact elements are made of CuSn6.

4. Electrical component according to any of Claims 1 to 3, **characterized in that**
the bonding layer is made of copper.

5. Electrical component according to any of Claims 1 to 4, **characterized in that**
the intermediate layer is made of silver.

6. Electrical component according to any of Claims 1 to 5, **characterized in that**
the top coating is made of tin or a lead-tin alloy.

7. Electrical component according to any of Claims 4 to 6, **characterized in that**
the layer thicknesses equal approximately 0.4 µm for the copper bonding layer, 1 - 2 µm for the silver intermediate layer, and 5 - 7 µm for the tin or lead/tin top layer.

## Revendications

1. Composant électrique, notamment inductance pastille pour le montage en surface, comprenant des éléments de contact en tôle métallique courbés sur le corps du composant et ayant, au moins dans une partie pouvant être brasée, un revêtement en un matériau pouvant être brasé,
**caractérisé**
**en ce qu'**il est disposé sur les éléments de contact une couche d'adhérence, sur la couche d'adhérence une couche intermédiaire, et sur la couche intermédiaire un revêtement final extérieur.

2. Composant électrique suivant la revendication 1,
**caractérisé**
**en ce que** les éléments de contact sont en bronze.

3. Composant électrique suivant la revendication 2,
**caractérisé**
**en ce que** les éléments de contact sont en CuSn6.

4. Composant électrique suivant l'une des revendications 1 à 3,
**caractérisé**
**en ce que** la couche d'adhérence est en cuivre.

5. Composant électrique suivant l'une des revendications 1 à 4,
**caractérisé**
**en ce que** la couche intermédiaire est en argent.

6. Composant électrique suivant l'une des revendications 1 à 5,
**caractérisé**
**en ce que** la couche finale est en étain ou en un alliage d'étain ou de plomb.

7. Composant électrique suivant l'une des revendications 4 à 6,
**caractérisé**
**en ce que** l'épaisseur de la couche d'adhérence en cuivre est d'environ 0,4 µm, l'épaisseur de la couche intermédiaire en argent est comprise entre 1 à 2 µm et l'épaisseur de la couche finale en étain ou en alliage d'étain et de plomb est comprise en 5 et 7 µm.
